# EUROPEAN PATENT APPLICATION

(11) **EP 4 790 853 A1**
(43) Date of publication of application: **12.08.2026**
(21) Application number: 25305178.3
(22) Date of filing: 07.02.2025
(51) Int. Cl.: H01S 5/042, H01S 5/04, H01S 5/06, H01S 5/183, H01S 5/062, H01S 5/347, H01S 5/34

(54) **LASER LIGHT SOURCE EMITTING IN THE TERAHERTZ GAP USING LANDAU POLARITONS**

(71) Applicant: UNIVERSITE DE MONTPELLIER, 34090 Montpellier (FR); Centre National de la Recherche Scientifique (CNRS), 75016 Paris (FR); Université Paris Cité, 75006 Paris (FR)
(72) Inventor: CIUTI, Cristiano, 75005 PARIS (FR); CONSEJO, Christophe, 34000 MONTPELLIER (FR); BENHAMOU-BUI, Benjamin, 34000 MONTPELLIER (FR); TEPPE, Frédéric, 34160 CASTRIES (FR)
(74) Representative: Regimbeau

(57) **Abstract**

The present disclosure relates to a laser light source device (1), comprising:
- a semiconductor substrate (3) comprising an active layer (9),
- an electron exciting device for exciting electrons within the active layer (9),
- a resonant optical cavity formed within the semiconductor substrate and containing the active layer (9), and
- a first mirror (5) and a second mirror (2) extending substantially parallel to one another, the resonant optical cavity extending between the first mirror (5) and the second mirror (2),
wherein the laser light source device (1) is configured to emit light radiation when:
- a magnetic field (M) is applied on the active layer (9), and
- the electron exciting device excites electrons within the active layer (9) so as to allow strong light-matter coupling resulting in the generation of Landau polaritons within the resonant optical cavity, the radiation having a frequency superior or equal to 0.5 THz and inferior or equal to 10 THz.

## Description

### TECHNICAL FIELD

The present disclosure belongs to the field of monochromatic lasers. More specifically, it deals with lasers capable of operating in the Terahertz (THz) frequency range, i.e. between 0.5 and 10 THz.

### STATE OF THE ART

The rise of technologies based on semiconductor materials has allowed for laser emitting devices of a new type. Semiconductor lasers (also referred to as laser diodes) allow for more compact devices than previous technologies of lasers and are typically more efficient. Quantum cascade lasers (QCLs) are a type of semiconductor-based laser that utilize a series of quantum wells to enable multiple photon emissions from a single electron as it sequentially transitions through the structure, leading to a much higher output power than typical lasers. However, although QCLs have a high output power in the mid-infrared range (approximately 13-100 THz), their output power is much lower at lower frequencies, and in particular at frequencies approaching the THz gap. For the purposes of the present disclosure, the THz gap can be defined as the frequency range from about 100 GHz to about 10 THz, which corresponds to a range of the electromagnetic spectrum at which current solid-state electronic and optical technologies are underdeveloped. Furthermore, QCLs, while tuneable within their optimal frequency range, have poor tunability at frequencies close to or within the THz gap.

Other solid-state based technological solutions have demonstrated the ability to produce high power at low frequencies. These solutions are generally of an electronic nature, such as Schottky and Gunn emitting diodes, which can be used as light sources and are commonly used in frequencies of the order of magnitude of 10 GHz or even up to 1 THz but yield poor output power when approaching 1 THz.

Moreover, like QCLs, the tunability of such solutions at frequencies near the THz gap is limited.

Laser light emitting devices whose technology is not based on semiconductor materials (such as gas-based lasers) can yield high output power at frequencies within the THz gap, however their much larger dimensions make them both unusable for some applications, and more expensive than semiconductor-based laser sources. Furthermore, THz gas lasers are not tunable.

### STATEMENT

A light source which can operate at frequencies close to the THz gap, notably between 500 GHz and 3 THz, is therefore needed with a high-power output and a high tuneability, while remaining compact and of limited cost.

To that effect, the present disclosure concerns, according to a first aspect, a laser light source device, comprising: a semiconductor substrate comprising an active layer, an electron exciting device for exciting electrons within the active layer, a resonant optical cavity formed within the semiconductor substrate and containing the active layer, and a first mirror and a second mirror extending substantially parallel to one another, the resonant optical cavity extending between the first mirror and the second mirror, wherein the laser light source device is configured to emit light radiation when : a magnetic field is applied on the active layer, and the electron exciting device excites electrons within the active layer so as to allow strong light-matter coupling resulting in the generation of Landau polaritons within the resonant optical cavity, the radiation having a frequency superior or equal to 0.5 THz and inferior or equal to 10 THz.

The proposed cyclotron laser, in which Landau polaritons are generated within the optical resonant cavity, allows for the obtention of a stimulated laser emission thanks to the amplification of the spontaneous emission of photons in the cavity, without requiring a population inversion. Advantageously, the laser source of the present disclosure needs an electric field of much lower intensity than in the prior art to operate. Hence, a tunable laser capable of operating at high powers - included within the THz band - is obtained, without the risk of reaching a breakdown voltage of the semiconductor material.

According to specific embodiments of the first aspect:
- the second mirror is a Bragg distributed reflector.
- the first mirror is a perfect mirror.
- the light radiation has a frequency superior or equal to 1.0 THz and inferior or equal to 3.0 THz.
- the electron exciting device is configured for generating an electric field.
- the active layer comprises: a semiconductor or semimetal heterostructure, in particular a quantum well or a film heterostructure, and/or a bulk semiconductor or semimetal crystal.
- the active layer comprises at least one material chosen among mercury telluride (HgTe), indium antimonide (InSb), indium arsenide (InAs), gallium arsenide (GaAs), gallium antimonide (GaSb), mercury cadmium telluride (HgCdTe), bismuth telluride (Bi2Te3), tungsten ditelluride (WTe2), p-doped germanium (p-Ge), lead tin telluride (PbSnTe), lead tin selenide (PbSnSe) and/or graphene.
- the active layer comprises a semiconductor material having preferably a non-parabolic dispersion relation.
- a working frequency of the laser light source device can be tuned by adjusting a gate voltage.

The invention concerns according to a second aspect an assembly for generating laser light radiation, comprising the laser light source device of the first aspect and a device for generating a magnetic field.

According to specific embodiments of the second aspect:
- the device for generating a magnetic field is configured for generating a permanent magnetic field, in particular the device for generating a magnetic field comprises a permanent magnet.
- the device for generating a magnetic field is configured for generating a magnetic field at an angle to a median plane of the active layer comprised between 60° and 120°, in particular between 85° and 95°, more particularly of 90°.

The invention concerns according to a third aspect a method for generating a laser light radiation using a laser light source device according to the first aspect, the method comprising:
- applying a magnetic field to a semiconductor substrate comprising an active layer, the active layer being contained in a resonant optical cavity placed between a first mirror (5) and a second mirror extending substantially parallel to one another, the second mirror comprising an aperture to allow the passage of light from the resonant optical cavity outwards,
- exciting electrons of the active layer via the device for exciting electrons, and
- applying a magnetic field on the active layer, so as to cause a strong light-matter interaction within the resonant optical cavity, resulting in the generation, excitation and condensation of Landau polaritons within the resonant optical cavity,
wherein the light radiation from Landau polaritons has a frequency superior or equal to 0.5 THz and inferior or equal to 10 THz.

### DESCRIPTION OF THE FIGURES

Other goals and advantages will be illustrated in the following description, whose purpose is illustrative and not limiting, and in which:

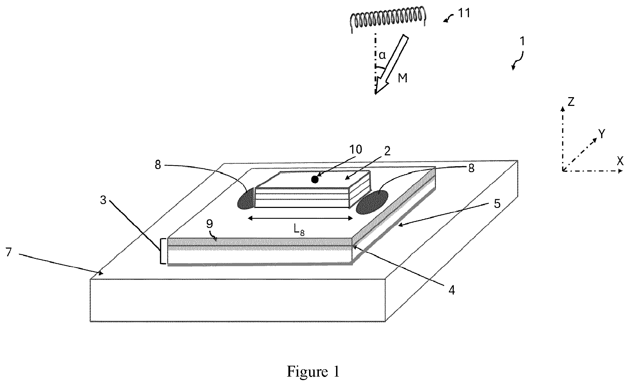

Figure 1 is a schematic representation of a laser light source device according to one embodiment.

Throughout the description, the same reference numerals refer to identical or similar features.

### DETAILED DESCRIPTION OF SPECIFIC EMBODIMENTS

Figure 1 represents one embodiment of a laser light emitting device 1. Device 1 comprises a semiconductor substrate 3 itself comprising an active layer 9.

In all of the following disclosure, the term "thickness" will be used to indicate the dimensions of a component along a Z-direction perpendicular to a median plane of active layer 9, on the understanding that active layer 9 has dimensions larger in directions X, Y (both perpendicular to direction Z) than in direction Z itself.

The active layer 9 is contained within a resonant optical cavity.

According to some embodiments, the resonant optical cavity extends between a first mirror 5 and a second mirror 2. Mirrors 2, 5 are substantially parallel to each other, so as to allow resonance of photons generated within the resonant optical cavity only for photons travelling within a narrow angular band around a gain direction defined perpendicular to the two mirrors 2, 5. Active layer 9 therefore corresponds to the active material portion of semiconductor substrate 3, which interacts with the resonant optical cavity. In optical terms, however, the resonant optical cavity in its entirety can be considered to be "active".

Preferably, active layer 9 is also parallel to mirrors 2, 5.

The resonant optical cavity is open on at least one side which extends within a plane perpendicular to mirrors 2, 5 so as to let out photons not travelling along the gain direction. Second mirror 2 is configured to allow the emission of a focused directional ray of light out of the resonant optical cavity, said ray having been reflected between mirrors 2, 5 several times before exiting the resonant optical cavity through the second mirror 2.

In order to provide mechanical support to laser light emitting device 1, first mirror 5 may be fixed on a substrate 7. Substrate 7 may for example comprise a ceramic material, silicon or quartz. Substrate 7 may also comprise a polymeric material, for example substrate 7 may be manufactured using a 3D-printing method.

Laser light emitting device 1 further comprises a device for exciting the electrons within active layer 9.

When electrical excitation of the electrons is desired instead of optical excitation, the device used for exciting the electrons can include ohmic contacts integrated within the active layer 9. This allows some of the electrons to reach a higher energy state.

The ohmic contacts allow for the application of a voltage across the active layer 9. As represented on figure 1, the ohmic contacts for exciting electrons can take the form of two contact layers 8 of a conductive material such as a metal, applied to active layer 9.

In order to control the density of electrons within the active layer 9, a gate voltage can be applied across semiconductor substrate 3. Preferably, a semi-transparent gate is used, in order to minimize radiative losses and to increase the light-matter coupling. The gate voltage can be applied through contacts located on a face of semiconductor substrate 3 closest to first mirror 5. This allows the portion of substrate 3 located between the ohmic contacts and active layer 9 to act as a dielectric insulator material between the gate and the active layer 9, which avoids direct contact between the gate and active layer 9.

In both cases, applying a gate voltage across substrate 3 modulates the number of electrons present within active layer 9, through a potential difference between the source and the drain. Contact layers 8 may, according to some embodiments, be formed manually using indium beads or pellets. In other embodiments, contact layers 8 may be engraved into semiconductor substrate 3 or using more elaborate metal deposition processes known to the skilled person, which may be carried out in a clean room.

Contact layers 8 may also comprise other metals than indium, in addition or instead of indium, such as gold, chromium or nickel.

According to specific embodiments, a distance L8 between the two contact layers 8 is between 10 µm and 1.00 mm, more preferably between a few tens of microns and a few hundreds of microns.

Contact layers 8 can advantageously contain a metal with a high diffusion coefficient on the material making up the active layer 9, so as to ensure adequate contact area between the contact layers 8 and the active layer 9.

Alternatively to contact layers 8, or more generally to ohmic components or intermediary capable of generating an electric field within active layer 9, the device for exciting the electrons within active layer 9 may be of an optical nature, i.e. it may be a monochromatic light source. Said monochromatic light source can be used to optically pump the electrons contained within active layer 9 so that they reach a higher energy state. Advantageously, such a light source is compact enough to not adversely affect the compacity of laser light device 1. Such a light source may for example comprise a quantum cascade laser.

When device 1 is exposed to a magnetic field, the electrons in active layer 9 will follow orbital trajectories, known as cyclotron orbits, around an axis aligned with the applied magnetic field as a result of the Lorentz force acting on them. This in turn leads to the apparition of a quantum discretization of orbital energy levels referred to as Landau levels. When electrons at, or below, the Fermi level are excited (such as electrically or optically) they can occupy higher-energy Landau levels; these excited electrons can then recombine to a lower-energy Landau level by emitting a photon, a process referred to as "Landau emission" or "cyclotron emission". It is further noted that, depending on the material's physical properties, the magnetic field to be applied depends on the intrinsic characteristics of the material, such as effective mass, mobility, and carrier's density.

For a predefined coupling frequency, the semiconductor substrate 3 is configured with an optimized thickness to enable strong coupling. For example, the thickness of the semiconductor substrate 3 is inferior to 50 µm, such as between 30 µm and 50 µm, or even inferior to 30 µm. It is noted that the optical cavity can be a Fabry-Perot cavity type (wherein the resonant modes are established across the width of the substrate 3) or a sub-wavelength cavity type including split-ring and plasmonic metallic resonators obtained by lateral, in-plane lithographic patterning (wherein the resonant modes are established across a transverse direction of the substrate 3, i.e., a direction perpendicular to the width of the substrate, hence depending on the lateral dimensions of the substrate 3).

Due to the excitation of the electrons, irrespective of the nature of the ohmic contacts for exciting the electrons, strong light-matter coupling takes place between the electrons themselves and photons confined within the resonant optical cavity, said photons being generated by a radiative recombination of electrons from one Landau level to another Landau level of lower energy.

The interaction between cyclotron transition and photons confined in resonant cavities which are necessarily present within active layer 9 lead to the appearance, within the resonant optical cavity, of quasi particles named Landau polaritons. The expression "strong light-matter coupling" denotes the level of light-matter coupling necessary to obtain said apparition of Landau polaritons.

The inventors have found that Landau polaritons enable a reduction in the amplification threshold for stimulated cyclotron emission. In other words, Landau polariton dynamics can lower the minimum injection power required for the laser to produce a coherent light beam, or to lower the excitation threshold at which stimulated emission starts to dominate the laser's behaviour. The generation, excitation and condensation of Landau polaritons allows for a lasing action without requiring an inversion of population.

As a result, the input power needed to excite the electrons in order to obtain a given power output from the laser source at frequencies within the THz gap is lowered. If the device for exciting the electrons is of an electric nature, the electric field which needs to be generated can be lower than in prior art lasers such that its intensity can be well under a breakdown voltage of semiconductor substrate 3. Equivalently, if the electrons are excited optically rather than electrically, laser light device 1 also enables the obtention of a given output power for the laser source with a lower input power than for priorly known semiconductor lasers.

The magnetic field's effects on the electrons enable the cyclotron resonance, which in turn enables the production of light if the electrons are excited - electrically or optically - and the polaritons are created only if the cyclotron resonance is strongly coupled to an optical mode of the resonant cavity (said cavity mode depending on the semiconductor substrate thickness, as aforementioned).

According to some embodiments, first mirror 5 comprises a metallic film, or a layer of material coated with a metal. First mirror 5 may for example comprise a film made of gold or of a gold-coated material. The film or coated material preferably has a thickness of at least a few nanometers. Metals has the advantage of high reflectance. Gold specifically has a particularly high reflectance in the long-wavelength infrared light spectrum and in the THz gap. The durability of metals, including gold, also contributes to the robustness of laser emitting device 1.

Concerning the resonant optical cavity, two simple mirrors may be used, however, second mirror 2 may advantageously comprise a Bragg distributed reflector, which is a structure formed of multiple layers of different materials, exhibiting distinct refractive indices. The presence of a Bragg reflector within second mirror 2 enables constructive interference between photons reflected off second mirror 2, and therefore increases the gain obtained within the portion of the resonant cavity located between second mirror 2 and active layer 9. Although any resonant optical cavity of adequate quality factor may be used, the resonant optical cavity may more specifically be a Tamm cavity, meaning that not only does second mirror 2 comprise a Bragg distributed reflector, but also that first mirror 5 is a so-called perfect mirror, understood here as a mirror reflecting substantially all of the light incident upon it. This further increases the gain operated on the radiation within the resonant optical cavity. Active layer 9 can, depending on the embodiment considered, take several forms. Notably, active layer 9 can be grown epitaxially from semiconductor substrate 3. Possible semiconductor or semimetal materials for active layer 9 can include one or several of mercury telluride (HgTe), indium antimonide (InSb), indium arsenide (InAs), gallium arsenide (GaAs), gallium antimonide (GaSb), mercury cadmium telluride (HgCdTe), bismuth telluride (Bi2Te3), tungsten ditelluride (WTe2), p-doped germanium (p-Ge), lead tin telluride (PbSnTe), lead tin selenide (PbSnSe), or graphene. Possible semiconductor materials for semiconductor substrate 3 (not including active layer 9) can include one or several of silicon (Si), cadmium telluride (CdTe), gallium arsenide (GaAs), or any semiconductor material substantially transparent at frequencies within the Terahertz gap - i.e., materials which have residual and nonintentional doping and therefore contain as few charge carriers as possible.

One advantage of the proposed laser emitting device 1 is that many semiconductor and semimetal materials which were considered inappropriate for a semiconductor-based cyclotron laser, due to the inability to easily obtain a population inversion within these materials (i.e., the charge carriers needed to be highly excited, for example with a very high electric field which could not be withstood by the material) are appropriate for laser emitting device 1 thanks to the lowering of the amplification threshold that device 1 allows for. Indeed, due to the combined use of cyclotron resonance and of the strong light-matter coupling regime, the proposed laser device 1 enables the obtention of a stimulated emission without having to excite the electrons excessively, enabling the use of a variety of different semiconductors or semimetals materials, including those mentioned in the above paragraph. In order to further increase the ability of active layer 9 to trap electrons in specific portions of active layer 9 so as to maximize light-matter coupling within said portions, active layer 9 may comprise a quantum well heterostructure. This allows for the formation of localized energy states from trapped electrons within the semiconductor active layer 9.

In some embodiments, in addition to quantum well heterostructures or in substitution of heterostructures, active layer 9 may comprise a bulk crystal. Such a bulk crystal is not thin in the sense that, unlike quantum wells where electrons are confined in two dimensions, it has a thickness that is not negligible compared to its other dimensions, allowing for the full three-dimensional behavior of the electrons. However, it also needs to be thin enough to be sensibly transparent to light within the appropriate range of frequencies for the considered emission.

Active layer 9 may, according to some embodiments, comprise a semiconductor material with a non-parabolic dispersion relation. The dispersion relation corresponds to the relationship between the energy of the electrons and their momentum within the semiconductor structure, and affects the electrons dynamics. Having a parabolic dispersion relation results in equidistant Landau levels within active layer 9, and therefore to the occurrence of Auger scattering: the non-radiative recombination of electrons from one Landau level to a Landau level of lower energy, release additional electrons (so-called "Auger" electrons) without releasing photons, i.e. without contributing to the radiation. On the other hand, using a material having a non-parabolic dispersion ensures non-equidistant Landau levels, and accordingly, the release of more photons during recombination of the excited electrons. Radiative recombination can still occur in a system with a parabolic band structure, but the emission is expected to be less intense than in the non-parabolic case, and population inversion is impossible. When strong coupling phenomena and Bose-Einstein condensation are taken into account, the amplification of spontaneous emission is facilitated in the non-parabolic case and also becomes possible in the parabolic case.

Notably, active layer 9 can comprise one or several quantum well(s) 4, i.e. narrow bands of a semiconductor material of narrower bandgap, sandwiched between two zones of a different semiconductor material of wider bandgap.

Active layer 9 may also comprise a, or a plurality of, thin film heterostructure(s). "Thin" refers to the fact that the thickness of the film is negligible in comparison to its dimensions in the other two directions of space, leading to quantum confinement in the direction of the thickness.

Preferably, quantum well 4 is narrow along the Z-direction, with a thickness of a few nanometers, ensuring quantum confinement of the electrons within a narrow space, which affects their energy states in the Z-direction. Quantum wells of mercury telluride (HgTe) may be used, this material exhibiting particularly non equidistant Landau levels.

In addition, or as an alternative to quantum well heterostructures, a layer or a few layers of graphene may be used as a part of active layer 9, as graphene also exhibits a non-parabolic and even linear dispersion relation, which is advantageous for reasons outlined above. Furthermore, graphene has highly tunable cyclotron resonance frequency, even at low magnetic field due to the relativistic nature of its Dirac electrons (relativistic pseudo-particles which have no mass, and which travel at the Fermi velocity in solids).

The semiconductor materials constituting active layer 9 and the operational intensity of the device for exciting the electrons - for instance, the intensity of the electric field used to that intent - are chosen so that laser emitting device 1 can, when subjected to a magnetic field of a given intensity, generate a light ray of frequency between 0.5 to 10 THz. In particular, the materials making up active layer 9 and the operational intensity of the device for exciting electrons are chosen to generate radiation at a frequency of 1.0 to 3.0 THz.

The present disclosure also relates to an assembly comprising the laser emitting device 1 described hereabove, as well as a device 11 for generating a magnetic field M. Magnetic device 11 may for example be one or several of: a solenoid, an electromagnet, a permanent magnet, a superconducting magnet. Hence, magnetic device 11 may be configured for generating a permanent or a tunable (i.e. intentionally variable) magnetic field.

One advantage of the laser emitting device 1 described above is that tunability of the device 1 over the range of interest of frequencies (namely, 0.5 - 10 THz) can also be obtained by varying the intensity of a gate voltage, while using for instance a permanent (non-tunable magnetic field M) magnet as magnetic device 11. For example, when an electric field is applied in order to excite the electrons within active layer 9, device 1 can be tuned by modifying the intensity of said gate voltage, even if the magnetic field M applied to active layer 9 remains constant. This is only possible in materials with non-parabolic band structures, as only in these materials the cyclotron mass, and thus the frequency at a given magnetic field, does depend on the carrier density.

Magnetic device 11 is configured to apply a magnetic field M to active layer 9, at an angle α with respect to direction Z. According to a preferred embodiment, α = 0°, meaning that, magnetic field M is applied perpendicularly to the median plane of active layer 9 (active layer 9 having a dimension along direction Z smaller than its dimensions along both directions X and Y normal to direction Z). However, angle α may differ from zero if active layer 9 is a bulk crystal, considered as three-dimensional. The same applies in the case of a two-dimensional system such as a quantum well or a graphene sheet, with the distinction that, in this case, only the component of the magnetic field perpendicular to the XY-plane contributes to the Lorentz force and thus to the cyclotron frequency.

According to other embodiments, magnetic field M may be applied at angles α ranging from 0° to 30° (i.e., magnetic field M is applied at an angle of 60 - 120° to the median plane of active layer 9), or from 0° to 5° (i.e., magnetic field M is applied at an angle of 85 - 95° to the median plane of active layer 9).

## Claims

1. A laser light source device (1), comprising:
- a semiconductor substrate (3) comprising an active layer (9),
- an electron exciting device for exciting electrons within the active layer (9),
- a resonant optical cavity formed within the semiconductor substrate and containing the active layer (9), and
- a first mirror (5) and a second mirror (2) extending substantially parallel to one another, the resonant optical cavity extending between the first mirror (5) and the second mirror (2),
wherein the laser light source device (1) is configured to emit light radiation when:
- a magnetic field (M) is applied on the active layer (9), and
- the electron exciting device excites electrons within the active layer (9) so as to allow strong light-matter coupling resulting in the generation of Landau polaritons within the resonant optical cavity, the radiation having a frequency superior or equal to 0.5 THz and inferior or equal to 10 THz.

2. The laser light source device (1) of claim 1, wherein the second mirror (2) is a Bragg distributed reflector.

3. The laser light source device (1) of claim 1 or 2, wherein the first mirror (5) is a perfect mirror.

4. The laser light source device (1) of one of the preceding claims, wherein the light radiation has a frequency superior or equal to 1.0 THz and inferior or equal to 3.0 THz.

5. The laser light source device (1) of one of the preceding claims, wherein the electron exciting device is configured for generating an electric field.

6. The laser light source device (1) of one of the preceding claims, wherein the active layer (9) comprises:
- a semiconductor or semimetal heterostructure, in particular a quantum well (4) or a film heterostructure, and/or
- a bulk semiconductor or semimetal crystal.

7. The laser light source device (1) of one of the preceding claims, wherein the active layer (9) comprises at least one material chosen among mercury telluride (HgTe), indium antimonide (InSb), indium arsenide (InAs), gallium arsenide (GaAs), gallium antimonide (GaSb), mercury cadmium telluride (HgCdTe), bismuth telluride (Bi2Te3), tungsten ditelluride (WTe2), p-doped germanium (p-Ge), lead tin telluride (PbSnTe), lead tin selenide (PbSnSe) and/or graphene.

8. The laser light source device (1) of one of the preceding claims, wherein the active layer (9) comprises a semiconductor material having preferably a non-parabolic dispersion relation.

9. The laser light source device (1) of the preceding claim, wherein a working frequency of the laser light source device (1) can be tuned by adjusting a gate voltage.

10. An assembly for generating laser light radiation, comprising the laser light source device (1) of one of claims 1 to 9 and a device (11) for generating a magnetic field.

11. The assembly of claim 10 comprising the laser light source device (1) of claim 8 or 9 wherein the device (11) for generating a magnetic field is configured for generating a permanent magnetic field, in particular the device (11) for generating a magnetic field comprises a permanent magnet.

12. The assembly of one of claims 10 and 11, wherein the device (11) for generating a magnetic field is configured for generating a magnetic field at an angle to a median plane of the active layer (9) comprised between 60° and 120°, in particular between 85° and 95°, more particularly of 90°.

13. A method for generating a laser light radiation using a laser light source device according to any of claims 1 to 10, the method comprising:
- applying a magnetic field (M) to a semiconductor substrate (3) comprising an active layer (9), the active layer (9) being contained in a resonant optical cavity placed between a first mirror (5) and a second mirror (2) extending substantially parallel to one another, the second mirror (2) comprising an aperture to allow the passage of light from the resonant optical cavity outwards,
- exciting electrons of the active layer (9) via the device for exciting electrons, and
- applying a magnetic field (M) on the active layer (9), so as to cause a strong light-matter interaction within the resonant optical cavity, resulting in the generation, excitation and condensation of Landau polaritons within the resonant optical cavity,
wherein the light radiation from Landau polaritons has a frequency superior or equal to 0.5 THz and inferior or equal to 10 THz.
